# EUROPEAN PATENT APPLICATION

(11) **EP 2 221 909 A1**
(43) Date of publication of application: **25.08.2010**
(21) Application number: 08858684.7
(22) Date of filing: 09.12.2008
(51) Int. Cl.: H01M 14/00, H01L 31/04, H01L 31/042

(54) **DYE-SENSITIZED PHOTOELECTRIC CONVERSION DEVICE MODULE AND METHOD FOR MANUFACTURING THE SAME, PHOTOELECTRIC CONVERSION DEVICE MODULE AND METHOD FOR MANUFACTURING THE SAME, AND ELECTRONIC DEVICE**

(30) Priority: 12.12.2007 JP 2007320261
(71) Applicant: Sony Corporation, Tokyo 108-0075 (JP)
(72) Inventor: MOROOKA, Masahiro, Tokyo 108-0075 (JP); ORIHASHI, Masaki, Tokyo 108-0075 (JP); TAKADA, Harumi, Tokyo 108-0075 (JP)
(74) Representative: Horner, David Richard
(86) International application number: PCT/JP2008/072340
(87) International publication number: WO 2009/075267

(57) **Abstract**

The present invention provides a dye-sensitized photoelectric conversion element module, such as a dye-sensitized solar cell module, which can be structured so as to be lightweight, thin and flexible, and with which a high electric power generation efficiency can be obtained, and a method of manufacturing the same. In a dye-sensitized photoelectric conversion element module having a plurality of dye-sensitized photoelectric conversion elements on a supporting base material, a filmy glass substrate 1 having a thickness of 0.2 mm or less is used as the supporting base material, and a resin system protective film 9, 11 having a size equal to or larger than that of the filmy glass substrate 1 is bonded to at least one surface of the dye-sensitized photoelectric conversion element module. A dye-sensitized semiconductor layer 3, a porous insulating layer 4, and a counter electrode 5 are laminated in order on a transparent conductive layer 2 formed on the filmy glass substrate 1, thereby structuring a dye-sensitized photoelectric conversion element module. The dye-sensitized semiconductor layer 3 and a porous insulating layer 4 are impregnated with an electrolyte.

## Description

### Technical Field

The present invention relates to a dye-sensitized photoelectric conversion element module and a method of manufacturing the same, and a photoelectric conversion element module and a method of manufacturing the same, and an electronic apparatus, and, for example, is suitable for being applied to a dye-sensitized solar cell module using a dye-sensitized semiconductor layer made of semiconductor fine particles supporting a dye, and various kinds of electronic apparatuses.

### Background Art

It is said that when fossil fuel such as coal or oil is used as an energy source, the global warning is caused because carbon dioxide is generated due to use of the fossil fuel. In addition, use of a nuclear energy is fraught with a risk of contamination due to nuclear radiation. At present when many people talk about the environmental concerns, dependency on these energies is fraught with problems.

On the other hand, the solar cell as a photoelectric conversion element for converting a solar light into an electrical energy exerts an extremely less influence on the global environment because it uses the solar light as the energy source, and thus is expected to be further widely used.

Although various materials are known as a material for the solar cell, a lot of solar cells each using silicon are offered commercially. These solar cells are roughly classified into a crystalline silicon system solar cell using single-crystalline or polycrystalline silicon, and an amorphous silicon system solar cell. Heretofore, single-crystalline or polycrystalline silicon, that is, crystalline silicon has been used in the solar cells in many cases.

However, although a photoelectric conversion efficiency representing a performance for converting a light (solar) energy into an electrical energy is higher in the crystalline silicon system solar cell than in the amorphous silicon system solar cell, the productivity was low in the crystalline silicon system solar cell because it took a lot of energy and time to glow a crystal, and thus the crystalline silicon system solar cell was disadvantageous in a cost phase.

In addition, the amorphous silicon system solar cell has the features that a light adsorbing property is high, a selection room of a substrate is wide, promotion for increasing an area is easily attained as compared with the crystalline silicon system solar cell. However, the photoelectric conversion efficiency is lower in the amorphous silicon system solar cell than in the crystalline silicon system solar cell. Moreover, although the amorphous silicon system solar cell has the higher productivity than that of the crystalline silicon system solar cell, the amorphous silicon system solar cell requires a vacuum process for manufacture similarly to the case of the crystalline silicon system solar cell, and thus still has a large burden in an equipment phase.

On the other hand, for the lower cost of the solar cells, many solar cells using organic materials instead of using the silicon system materials have been searched. However, the photoelectric conversion efficiency of such a solar cell is so very low as to be equal to or smaller than 1%, and involves a problem about a durability as well.

Under such circumstances, an inexpensive solar cell using semiconductor fine particles sensitized by a dye is reported (refer to Nature, 353, p. 737 to 740, 1991). This solar cell is a wet solar cell which has a titanium oxide porous thin film spectroscopically sensitized by using a ruthenium complex as a sensitizing dye as a photo-electrode, that is, an electrochemical solar cell. The advantages of this dye-sensitized solar cell are such that an inexpensive titanium oxide can be used, light absorption of the sensitizing dye is over a wide visible light wavelength range up to 800 nm, and a high energy conversion efficiency can be realized because a quantum efficiency in photoelectric conversion is high. In addition, since the vacuum process is unnecessary in manufacture, the large-scaled equipment is not required. Moreover, this dye-sensitized solar cell has worldwide attracted attention because it has a designing property such as "see-through," "flexible," and "colorful" which is lacked in the conventional silicon system solar cell.

In recent years, the action for developing dye-sensitized solar cell modules has been activated. Of these dye-sensitized solar cell modules, in particular, the flexible solar cell module using a plastic substrate as a supporting base material is being actively developed. However, although a burning treatment for formation of a porous semiconductor layer used in a dye-sensitized semiconductor layer is required in a process for manufacturing the general dye-sensitized solar cell module, when the plastic substrate is used as the supporting base material as described above, in relation to a heatproof temperature (glass transition temperature) of the plastic substrate, a heating temperature in a phase of the burning can be made to rise merely up to about 150°C. For this reason, at present, the crystalline property of the resulting porous semiconductor layer, and the bonding state of the particles are poor. Since in such a state, an electron conductivity is low, an electric power generation efficiency of the dye-sensitized solar cell module using the plastic substrate is so low as to be less than half that of the dye-sensitized solar cell module using the glass substrate.

In the light of the foregoing, a problem to be solved by the present invention is to provide a dye-sensitized photoelectric conversion element module such as a dye-sensitized solar cell module which can be structured so as to be lightweight, thin and flexible, and with which a high electric power efficiency can be obtained, and a method of manufacturing the same, and an electronic apparatus using the excellent dye-sensitized photoelectric conversion element module.

In more general, the problem to be solved by the present invention is to provide a photoelectric conversion element module, such as any of various kinds of solar cell modules including a dye-sensitized solar cell module and a silicon system solar cell module, which can be structured so as to be lightweight, thin and flexible, and with which a high electric power efficiency can be obtained, and a method of manufacturing the same, and an electronic apparatus using the excellent photoelectric conversion element module.

### Disclosure of Invention

In order to solve the problems described above, according to the first invention, there is provided a dye-sensitized photoelectric conversion element module having a plurality of dye-sensitized photoelectric conversion elements on a supporting base material, the dye-sensitized photoelectric conversion element module being characterized in that:
a filmy glass substrate having a thickness of 0.2 mm or less is used as the supporting base material, and a resin system protective film having a size equal to or larger than that of the filmy glass substrate is bonded to at least one surface of the dye-sensitized photoelectric conversion element module.

In the first invention, the filmy glass substrate is used as the supporting base material, whereby a burning treatment can be carried out at a high temperature of about 500°C in a phase of formation of a porous semiconductor layer used in a dye-sensitized semiconductor layer. Therefore, a high electric power generation efficiency can be obtained because a crystalline property, and a bonding state of particles in the porous semiconductor layer become satisfactory, and thus the high electron conductivity can be obtained. In addition, the filmy glass substrate having the thickness of 0.2 mm or less can be not only readily bent, i.e., flexible, but also lightweight similarly to the case of the plastic substrate. The filmy glass substrate is readily bent as a thickness thereof is smaller, which leads to the weight saving. However, when the thickness becomes too small, the mechanical strength is reduced too much. Therefore, a preferred thickness exists from these viewpoints. Specifically, the thickness is preferably in the range of 0.01 to 0.2 mm. The filmy glass substrate having the thickness of 0.2 mm or less may be made by thinning a thicker glass substrate through polishing, or the filmy glass substrate may be used which is made to have this thickness from the beginning. A material for the filmy glass substrate is not especially limited, and any of various kinds of conventionally known materials can be used. Thus, the material for the filmy glass substrate is suitably selected from these various kinds of materials. The filmy glass substrate can also be made in the form of a hardened glass as may be necessary, thereby making it possible to increase the mechanical strength thereof.

On the other hand, in the case of the filmy glass substrate having the thickness of 0.2 mm or less, when a fine crack or damage exists on a surface or an end surface, breaking readily occurs in some cases. That is to say, it is not too much to say that the mechanical strength of the filmy glass substrate depends on the smoothness of the surface or end surface of the filmy glass substrate. Thus, for the purpose of preventing the breaking of the filmy glass substrate and therefore for the purpose of preventing the destruction of the dye-sensitized photoelectric conversion element module, a resin system protective film having a size equal to or larger than that of the filmy glass substrate is bonded to at least one surface, desirably, both the surfaces of the dye-sensitized photoelectric conversion element module. The entire surface of the at least one surface of the dye-sensitized photoelectric conversion element module is covered with the protective film, whereby it is possible to greatly enhance the mechanical strength of the dye-sensitized photoelectric conversion element module against the bending. Thus, it is possible to dramatically reduce the breaking of the filmy glass substrate and therefore it is possible to prevent the destruction of the dye-sensitized photoelectric conversion element module. For the purpose of further enhancing the mechanical strength of the dye-sensitized photoelectric conversion element module against the bending, desirably, at least a part, suitably, all the possible of the end surface of the filmy glass substrate are covered with the protective film. For this reason, when the protective film is bonded to only one surface of the dye-sensitized photoelectric conversion element module, preferably, the protective film is folded and so forth to cover the end surface of the filmy glass substrate. When the protective films are bonded to the both surfaces of the dye-sensitized photoelectric conversion element module, respectively, preferably, these protective films are joined to each other in portions thereof sticking out from the filmy glass substrate, thereby covering the end surface of the filmy glass substrate. The protection for the end surface of the filmy glass substrate is preferably made for the entire periphery of the filmy glass substrate. However, when the filmy glass substrate is polygonal, and sides to be bent are determined over one or more sides, it is desirable to cover the end surfaces of at least one or more sides. Transparent materials are used as a protective film and an adhesive agent which are bonded to a light incidence side surface of the dye-sensitized photoelectric conversion element module.

Typically, the dye-sensitized photoelectric conversion element module has a transparent conductive layer on a plurality of areas of the filmy glass substrate, a dye-sensitized semiconductor layer, a porous insulating layer and a counter electrode are laminated in order on each of the transparent conductive layers, thereby structuring a dye-sensitized photoelectric conversion element, and the protective film is bonded on a surface on a side of the dye-sensitized photoelectric conversion element of the dye-sensitized photoelectric conversion element module, thereby covering the dye-sensitized photoelectric conversion element with the protective film. When a plurality of dye-sensitized photoelectric conversion elements on the filmy glass substrate are electrically connected in series with one another, the transparent conductive layer of one dye-sensitized photoelectric conversion element, and the counter electrode of another dye-sensitized photoelectric conversion element are electrically connected to each other in a portion defined between the two dye-sensitized photoelectric conversion elements adjacent to each other. At least the dye-sensitized semiconductor layer and the porous insulating layer, typically, the counter electrode in addition to the dye-sensitized semiconductor layer and the porous insulating layer are impregnated with an electrolyte. The transparent conductive layer formed on a plurality of areas on the filmy glass substrate may be patterned before the dye-sensitized semiconductor layer, the porous insulating layer and the counter electrode are laminated in order, or may be patterned after the dye-sensitized semiconductor layer, the porous insulating layer and the counter electrode are laminated in order. This patterning can be carried out by utilizing any of the various kinds of etching methods, laser scribe, physical polishing processing or the like which is conventionally known.

A surface resistance (sheet resistance) of the transparent conductive layer formed on the filmy glass substrate is preferable as the surface resistance thereof is set as being lower. Specifically, the surface resistance of the transparent conductive layer is preferably equal to or lower than 500 Ω/□, and is more preferably equal to or lower than 100 Ω/□. The known material can be used as a material for the transparent conductive layer. Specifically, although there are given an indium-tin composite oxide (ITO), fluorine-doped SnO₂ (FTO), antimony-doped SnO₂ (ATO), SnO₂, ZnO, indium-zinc composite oxide (IZO), or the like, the present invention is by no means limited thereto. Also, a material obtained by combining two or more kinds of materials described above with one another can also be used. In addition, for the purpose of enhancing a power collection efficiency by reducing the surface resistance of the transparent conductive substrate having the transparent conductive layer formed on the filmy glass substrate, a wiring made of a metal or the like having a high conductivity or a conductive material such as carbon may be specially provided. Although there is especially no limit to the conductive material used in the wiring, the conductive material desirably has a high corrosion resistance, a high oxidation resistance, and a low leakage current of the conductive material itself.

The dye-sensitized semiconductor layer is typically a porous semiconductor layer made of semiconductor fine particles supporting a dye. In addition to an elemental semiconductor typified by silicon, various kinds of compound semiconductors, a compound having a perovskite structure, or the like can be used as the material for the semiconductor fine particle. Each of these semiconductors is preferably an n-type semiconductor in which the electrons in a conduction band become the carriers under photo-excitation to give an anode current. Concretely exemplifying, these semiconductors are TiO₂, ZnO, WO₃, Nb₂O₅, TiSrO₃, SnO₂, and the like. Of them, anatase-type TiO₂ is especially preferable. The kind of semiconductor is by no means limited thereto, and thus a semiconductor material obtained by mixing two or more kinds of semiconductors described above can also be used. Moreover, the semiconductor fine particle can take various kinds of forms such as a particle-shaped form, a tube-shaped form, and a rod-shaped form as may be necessary.

Although there is especially no limit to a particle diameter of the semiconductor fine particle, the particle diameter of the semiconductor fine particle is preferably in the range of 1 to 200 nm in average particle diameter of the original particle, and is especially preferably in the range of 5 to 100 nm in average particle diameter of the original particle. In addition, it is possible that the semiconductor fine particles each having that average particle diameter are mixed with the semiconductor fine particles each having an average particle diameter larger than that average particle diameter, and an incident light is scattered by the semiconductor fine particles each having the larger average particle diameter, thereby enhancing a quantum yield. In this case, the average particle diameter of the semiconductor fine particles for special mixing is preferably in the range of 20 to 500 nm.

Although there is especially no limit to a method of manufacturing the semiconductor layer made of the semiconductor fine particles, a wet film forming method is preferable when the physicality, the convenience, the manufacture cost, and the like are taken into consideration. Also, a method is preferable in which a paste obtained by uniformly dispersing powders or a sol of semiconductor fine particles into a solvent such as water or an organic solvent is prepared and is then applied onto a transparent conductive substrate. There is especially no limit to a method for the application, and thus the application can be carried out in accordance with the known method. For example, the application can be carried out in accordance with a dip method, a spray method, a wire-bar method, a spin coat method, a roller coat method, a blade coat method, or a gravure coat method. In addition, the application can also be carried out in accordance with a wet printing method. Here, the wet printing method is typified by various kinds of methods such as anastatic printing, offset, gravure, copper plate printing, rubber plate printing, and screen printing. When a crystalline titanium oxide is used as the material for the semiconductor fine particle, a crystal type thereof is preferable an anatase type from a viewpoint of photocatalytic activity. The anatase type titanium oxide may be commercially available powder, sol or slurry. Or, the anatase type titanium oxide having a predetermined particle diameter may also be made by utilizing a known method of, for example, hydrolyzing a titanium oxide alkoxide. When the commercially available powder is used, the secondary aggregation is preferably resolved. Also, in a phase of preparation of the application liquid, the particles are preferably dispersed by using a mortar, a ball mill, an ultrasonic dispersion device or the like. At this time, in order to prevent the particles resolved from the secondary aggregation from aggregating again, it is possible to add acetylacetone, a hydrochloric acid, a nitric acid, a surface active agent, a chelate agent or the like. In addition, for thickening, it is possible to add various kinds of thickening agents such as a polymer molecule such as polyethylene oxide or polyvinyl alcohol, and a cellulose system thickening agent.

The semiconductor layer made of the semiconductor fine particles, in other words, the semiconductor fine particle layer is preferably large in surface area thereof so as to be able to adsorb many sensitizing dyes. For this reason, a surface area in a state of applying the semiconductor fine particle layer onto a supporting body is preferably 10 or more times as large as that of a projected area, and is more preferably 100 or more times as large as that of the projected area. Although there is especially no limit to an upper limit of the surface area, the surface area is normally about 1000 times as large as that of the projected area. In general, a rate of capturing a light becomes high because an amount of dyes supported per unit projected area increases as a thickness of the semiconductor fine particle layer further increases. However, a loss due to a recombination of the electric charges also increases because a diffusion distance of each of the injected electrons increases. Therefore, although a preferred thickness exists in the semiconductor fine particle layer, the preferred thickness is generally in the range of 1 to 100 µm, is more preferably in the range of 1 to 50 µm, and is especially, preferably in the range of 3 to 30 µm. It is preferable that the particles are made to electronically contact each other after the semiconductor fine particle layer is applied onto a supporting body, and are burnt for the purpose of enhancing a film strength, and enhancing adhesiveness to the substrate. Although there is especially no limit to the range of a burning temperature, the burning temperature is normally in the range of 40 to 700°C, and is more preferably in the range of 40 to 650°C because when the burning temperature is made to rise too much, a resistance of the substrate increases, and the substrate may be melt. In addition, although there is especially no limit to a burning time, the burning time is normally in the range of about 10 minutes to about 10 hours. For the purpose of increasing a surface area of the semiconductor fine particle layer, and enhancing necking between the semiconductor fine particles, for example, there may be carried out chemical plating using a titanium tetrachloride solution, a necking treatment using a titanium trichloride solution, a dip treatment for the semiconductor ultra-fine particle sol having a diameter of 10 nm or less, or the like.

The dye supported by the semiconductor layer is not especially limited as long as it exhibits a sensitizing operation. For example, there is given a xanthene system dye such as Rhodamine B, rose bengal, eosine or erythrocine, a cyanine system dye such as merocyanine, quinocyanine or cryptocyanine, a basic dye such as phenosafranine, Cabri Blue, thiocine or Methylene Blue, or a porphyrin system compound such as chlorophyll, zinc porphyrin, or magnesium porphyrin. With regard to other dyes, there are given an azo dye, a phthalocyanine compound, a coumalin system compound, a Ru bipyridine complex compound, an Ru terpyridine complex compound, an anthraquinone system dye, a polycyclic quinone system dye, squarylium, and the like. Of them, the Ru bipyridine complex compound is especially preferable because a quantum yield thereof is high. However, the sensitizing dye is by no means limited thereto, and thus two or more kinds of sensitizing dyes described above may be mixed with one another.

A method of adsorbing the dye to the semiconductor layer is not especially limited. However, the sensitizing dyes described above can be dissolved in a solvent such as an alcohol class, a nitryle class, nitromethane, hydrocarbon halide, an ether class, dimethyl sulfoxide, an amide class, N-methylpyrrolidone, 1, 3-dimethylimidazolidinone, 3-methyloxazolidinone, an ester class, a carbonate ester class, a ketone class, hydrocarbon, and water. Also, the semiconductor layer can be immersed in the solvent described above, or the dye solution can be applied onto the semiconductor layer. In addition, when the dye having a high acidity, a deoxycholic acid or the like may be added for the purpose of reducing association between the dye molecules.

After the sensitizing dye is adsorbed, a surface of the semiconductor electrode may be processed by using an amine class for the purpose of promoting the removal of the excessively adsorbed sensitizing dye. Pyridine, 4-tert-butylpyridine, polyvinylpyridine or the like is given as an example of the amine class. When such an amine class is a liquid, it may be used as it is, or may be dissolved in an organic solvent to be used.

A material for the porous insulating layer is not especially limited so long as it has no conductivity. In particular, an oxide containing therein at least one or more kinds of elements selected from the group consisting of Zr, Al, Ti, Si,Zn, W and Nb, especially, zirconia, alumina, titania, silica or the like is desirably used. Typically, a fine particle of this oxide is used. A porosity of the porous insulating layer is preferably equal or larger than 10%. Although there is no limit to an upper limit of the porosity, the porosity is normally, preferably in the range of about 10 to about 80% from a viewpoint of the physical strength of the porous insulating layer. The porosity is equal to or smaller than 10%, which exerts an influence on the diffusion of the electrolyte, thereby remarkably reducing the characteristics of the dye-sensitized photoelectric conversion element module. In addition, a micropore diameter of the porous insulating layer is preferably in the range of 1 to 1000 nm. When the micropore diameter is smaller than 1 nm, which exerts an influence on the diffusion of the electrolyte, and the impregnation of the dye, thereby reducing the characteristics of the dye-sensitized photoelectric conversion element module. Moreover, when the micropore diameter is larger than 1000 nm, there is caused the possibility that short-circuit is caused because the catalytic particles of the counter electrode invades into the porous insulating layer. Although there is no limit to a method of manufacturing the porous insulating layer, the porous insulating layer is preferably a sintered body of the oxide particles described above.

A material for the counter electrode is not especially limited, and thus when a material itself having a catalytic activity has a conductive property, this material can be used in the counter electrode as it is. When the catalyst itself does not have the conductive property, a combination of a conductive material and a material having the catalytic activity can also be used. Specifically, for example, the counter electrode preferably contains therein at least one or more kinds of elements selected from the group consisting of Pt, Ru, Ir and C. Among other things, the counter electrode preferably contains therein Pt or C. In particular, the counter electrode preferably contains therein C because carbon black as a material containing therein C is inexpensive.

The counter electrode may be formed from a foil, made of a metal or an alloy, having a catalyst layer on one surface on the porous insulating layer side, or a foil made of a material having a catalytic ability. In this case, since the counter electrode can be structured so as to be thin, the miniaturization and weight saving of the dye-sensitized photoelectric conversion element module become possible. In addition, each of the material for the foil, made of either the metal or the alloy, forming the counter electrode, and the material, having the catalytic ability, forming the counter electrode, has a wide room of selection, and thus there is no restriction in material for the counter electrode. Moreover, since the dye-sensitized semiconductor layer and the counter electrode are separated from each other through the porous insulating layer, the dyes of the dye-sensitized semiconductor layer can be prevented from being adsorbed on the counter electrode, and thus no deterioration of the characteristics is caused. A foil made of either a metal or an alloy containing therein at least one or more kinds of elements selected from the group consisting of Ti, Ni, Cr, Fe, Nb, Ta, W, Co and Zr is preferably used as the foil, made of either the metal or the alloy, forming the counter electrode. The material having either the catalyst layer or the catalytic ability provided on the one surface, on the porous insulating layer side, of the foil made of either the metal or the alloy preferably contains therein at least one or more kinds of elements selected from the group consisting of Pt, Ru, Ir and C. A thickness of the counter electrode, that is, a total of thicknesses of the foil made of either the metal or the alloy, and the catalyst layer, or a thickness of the material having the catalytic ability is preferably equal to or smaller than 0.1 mm from a viewpoint of the thinning of the dye-sensitized photoelectric conversion element module. For supporting the catalyst layer on the foil made of either the metal on the alloy, it is possible to use a method of wet-coating a solution containing therein a catalyst or a precursor of the catalyst, a dry type method such as a sputtering method, a vacuum evaporation method or a chemical vapor deposition (CVD) method or the like. In this case, the counter electrode and the transparent conductive layer may be directly joined to each other, or may be joined to each other through a conductive material. In the latter case, specifically, the counter electrode and the transparent conductive layer, for example, is joined to each other through a conductive adhesive agent, or a low-melting point metal having a melting point of 300°C or less, or an alloy. A commercially available silver, carbon, nickel or copper paste, or the like can be used as the conductive adhesive agent, and in addition thereto, an anisotropically conductive adhesive agent or a film-shaped agent can also be used. In addition, various kinds of low-melting point metals or alloys such as In and an In-Sn system solder capable of being joined to the transparent conductive layer can also be used. Moreover, when a joining portion between the counter electrode and the transparent conductive layer directly contact the electrolyte, the joining portion may be protected with e resin, thereby preventing the joining portion from directly contacting the electrolyte.

Although a material for the protective film is not especially limited as long as the material is resin system one, suitably, a material having a high gas barrier property is used as the material for the protective film. Specifically, for example, the material having a high gas barrier property which is equal to or smaller than 100 (cc/m²/day/atm) in permeation rate of oxygen, and is equal to or smaller than 100 (g/m²/day) in permeation rate of water vapor is used as the material for the protective film. A film having a gas barrier property typified by an armoring film for foods, for example, is used as the material for the protective film. Suitably, a film, having a gas barrier property, which is obtained by laminating at least one or more kinds of materials, each having a gas barrier property, selected from the group consisting of aluminum, silica and alumina, or the like is used as the material for the protective film. The protective film is suitably sealed under a reduced pressure and in an inactive gas atmosphere. Such a protective film is provided on either a surface on the side of the dye-sensitized photoelectric conversion element of the dye-sensitized photoelectric conversion element module, or a back surface of the filmy glass substrate, which results in that gas such as oxygen, water vapor or the like can be prevented from penetrating from the outside into the inside of the dye-sensitized photoelectric conversion element module. Therefore, it is possible to suppress deterioration of the characteristics such as the photoelectric conversion efficiency, and it is possible to improve the durability of the dye-sensitized photoelectric conversion element module. Although a material for a bonding layer used for the bonding of the protective film is not especially limited, it is preferable to use an electrically insulating material which has a high gas barrier property, and which is chemically inactive. Specifically, it is possible to use a resin, a glass frit or the like. More specifically, it is possible to use various kinds of ultraviolet (UV) curable resins such as an epoxy resin, an urethane resin, a silicone resin, and an acrylic resin, various kinds of thermosetting resins, a hot-melt resin, a low-melting-point glass frit, or the like. Although this bonding layer is preferably integrated with the protective film, the present invention is by no means limited thereto.

In addition to a combination of iodine (I₂) and a metal iodide or an organic iodide, or a combination of bromine (Br₂), and a metal bromide or an organic bromide, a metal complex such as a ferricyanic acid chloride/ferricyanic acid chloride, or ferrocene/ferricinum ion, a sulfur compound such as sodium polysulfide, or alkyl thiollalkyl disulfide, or a viologen dye, hydroquinone/quinone, or the like can be used as the electrolyte. Li, Na, K, Mg, Ca, Cs or the like is preferable as a cation of the metal compound described above, and a quaternary ammonium compound such as a tetraalkyl ammonium class, a pyridinium class or an imidazolium class is preferable as a cation of the organic compound described above. However, the present invention is by no means limited thereto. In addition, a material obtained by mixing two or more kinds of materials described above can also be used. Of them, the electrolyte obtained by combining I₂, and LiI, NaI or the quaternary ammonium compound such as imidazoliumiodide with each other is preferable. A concentration of an electrolyte salt is preferably in the range of 0.05 to 5 M for a solvent, and is more preferably in the range of 0.2 to 3 M for the solvent. A concentration of I₂ or Br₂ is preferably in the range of 0.0005 to 1 M, and is more preferably in the range of 0.001 to 0.3 M. In addition, an additive made of an amine system compound typified by 4-tert-butylpyridine may be added for the purpose of enhancing an open voltage.

Water, an alcohol class, an eter class, an ester class, a carbonate ester class, a lactone class, a carboxylate ester class, a triester phosphate class, a heterocyclic compound class, a nitryl class, a keton class, an amide class, nitromethane, hydrocarbon halide, dimethyl sulfoxide, sulfolane, N-methylpyrrolidone, 1,3-dimethyl imidazolidinone, 3-methyl-oxazolidinone, hydrocarbon, or the like is given as the solvent composing the electrolyte composition described above. However, the present invention is by no means limited thereto, and thus a material obtained by mixing two or more kinds of materials described above can also be used. Moreover, an ion liquid of a tetraalkyl system, a pyridinium system, or an imidazolium system quaternary ammonium salt can also be used as the solvent.

For the purpose of reducing liquid leakage of the dye-sensitized photoelectric conversion element, and volatilization of the electrolyte, a gelatinizing agent, polymer, cross-linked monomer, or the like can be dissolved in the electrolyte composition described above, and in addition thereto, inorganic ceramic particles can be dispersed into the electrolyte composition. Thus, the resulting material can also be used as a gel-like electrolyte. With regard to a ratio between a gel matrix and the electrolyte composition, when an amount of electrolyte composition is much, an ion conductivity increases, but a mechanical strength decreased. Conversely, when the amount of electrolyte composition is too less, the mechanical strength is large, but the ion conductivity decreases. Therefore, the electrolyte composition is desirably in the range of 50 to 99 wt% of the gel-like electrolyte, and is more preferably in the range of 80 to 97 wt%. In addition, the electrolyte described above and a plasticizer are both dissolved in polymer, and the plasticizer is volatilized to be removed, thereby making it also possible to realize a total solid type dye-sensitized photoelectric conversion element module.

A method of manufacturing the dye-sensitized photoelectric conversion element module is not especially limited. However, when the thicknesses of the layers, the productivity, the pattern precision, and the like are taken into consideration, the semiconductor layer, the porous insulating layer, the counter electrode and the bonding layer, and moreover the catalyst layer in the case where the counter electrode has the catalyst layer before the dye is adsorbed are all preferably formed by utilizing the wet application method such as the screen printing or the spray application, and are especially, preferably all formed by utilizing the screen printing. The semiconductor layer and the porous insulating layer before the dye is adsorbed are preferably formed by the application and burning of the paste containing therein the particles composing the respective layers. The porosities of the respective layers are determined depending on a ratio between the binder component and the particles of the paste. Although the counter electrode is similarly, preferably formed by the application and burning of the paste, when the adsorption of the dye on the counter electrode exerts an influence on the characteristics, the dye may be adsorbed on the semiconductor layer in a stage in which up to the semiconductor layer and porous insulating layer are formed, and after that, the counter electrode may be formed on the porous insulating layer. When the counter electrode is formed from the member having the catalyst layer on one surface on the side of the porous insulating layer of the foil made of either the metal or the alloy, the catalyst layer, on the foil, made of either the metal or the alloy is directed toward the porous insulating layer side, and the counter electrode is joined to the transparent conductive layer of the adjacent dye-sensitized photoelectric conversion element. The filling of the electrolyte for impregnating the dye-sensitized semiconductor layer, the porous insulating layer and the like of each of the dye-sensitized photoelectric conversion elements with the electrolyte, for example, can be carried out by utilizing a method using a dispenser, printing, ink jet or the like. However, in the dye-sensitized photoelectric conversion element module having a plurality of dye-sensitized photoelectric conversion elements connected in series with one another, flowing-out of the electrolyte results in that short-circuit occurs between the dye-sensitized photoelectric conversion elements. Therefore, it is not preferable to add an amount of electrolyte than is needed to impregnate the dye-sensitized semiconductor layer, the porous insulating layer and the like of each of the dye-sensitized photoelectric conversion elements with the electrolyte.

The dye-sensitized photoelectric conversion element module can be manufactured into various shapes depending on applications thereof, and thus the shape thereof is not especially limited.

The dye-sensitized photoelectric conversion element module is most typically structured as the dye-sensitized solar cell module. However, the dye-sensitized photoelectric conversion element module may also be structured as any other suitable one other than the dye-sensitized solar cell module, for example, as a dye-sensitized photosensor or the like.

According to the second invention, there is provided a method of manufacturing a dye-sensitized photoelectric conversion element module having a plurality of dye-sensitized photoelectric conversion elements on a supporting base material, the method being characterized by having:
the step of using a filmy glass substrate having a thickness of 0.2 mm or less as the supporting base material, and forming the plurality of dye-sensitized photoelectric conversion elements on the filmy glass substrate, thereby forming the dye-sensitized photoelectric conversion element module; and
the step of bonding a resin system protective film having a size equal to or larger than that of the filmy glass substrate to at least one surface of the dye-sensitized photoelectric conversion element module.

In the method of manufacturing the dye-sensitized photoelectric conversion element module, typically, when a dye-sensitized semiconductor layer, a porous insulating layer and a counter electrode are laminated in order on a transparent conductive layer, thereby forming the dye-sensitized photoelectric conversion elements, the transparent conductive layer of one dye-sensitized photoelectric conversion element, and the counter electrode of another dye-sensitized photoelectric conversion element are electrically connected to each other in portion thereof between the two dye-sensitized photoelectric conversion elements adjacent to each other.

In the second invention, with regard to any of the matters other than the foregoing, the matter described in connection with the first invention is established unless it departs from the nature thereof.

According to the third invention, there is provided an electronic apparatus using a dye-sensitized photoelectric conversion element module, the electronic apparatus being characterized in that:
the dye-sensitized photoelectric conversion element module is a dye-sensitized photoelectric conversion element module having a plurality of dye-sensitized photoelectric conversion elements on a supporting base material; and
a filmy glass substrate having a thickness of 0.2 mm or less is used as the supporting base material, and a resin system protective film having a size equal to or larger than that of the filmy glass substrate is bonded to at least one surface of the dye-sensitized photoelectric conversion element module.

The electronic apparatus may be basically any type one, and thus includes portable type one and stationary type one. Giving concrete examples, there are a mobile phone, a mobile device, a robot, a personal computer, an on-board apparatus, various kinds of home electric appliances, and the like. In this case, the dye-sensitized photoelectric conversion element module, for example, is a dye-sensitized solar cell used as a power source of any of these electronic apparatuses.

In the third invention, with regard to any of the matters other than the foregoing, the matter described in connection with the first invention is established unless it departs from the nature thereof.

According to the fourth invention, there is provided a photoelectric conversion element module having a plurality of photoelectric conversion elements on a supporting base material, the photoelectric conversion element module being characterized in that:
a filmy glass substrate having a thickness of 0.2 mm or less is used as the supporting base material, and a resin system protective film having a size equal to or larger than that of the filmy glass substrate is bonded to at least one surface of the photoelectric conversion element module.

According to the fifth invention, there is provided a method of manufacturing a photoelectric conversion element module having a plurality of photoelectric conversion elements on a supporting base material, the method being characterized by having:
the step of using a filmy glass substrate having a thickness of 0.2 mm or less as the supporting base material, and forming the plurality of photoelectric conversion elements on the filmy glass substrate, thereby forming the photoelectric conversion element module; and
the step of bonding a resin system protective film having a size equal to or larger than that of the filmy glass substrate to at least one surface of the photoelectric conversion element module.

According to the sixth invention, there is provided an electronic apparatus using a photoelectric conversion element module, the electronic apparatus being characterized in that:
the photoelectric conversion element module is a photoelectric conversion element module having a plurality of photoelectric conversion elements on a supporting base material; and
a filmy glass substrate having a thickness of 0.2 mm or less is used as the supporting base material, and a resin system protective film having a size equal to or larger than that of the filmy glass substrate is bonded to at least one surface of the photoelectric conversion element module.

In the fourth to sixth inventions, the photoelectric conversion element contains therein not only the dye-sensitized photoelectric conversion element such as the dye-sensitized solar cell, but also the conventionally known photoelectric conversion element such as the silicon system solar cell.

In the fourth to sixth inventions, with regard to any of the matters other than the foregoing, the matter described in connection with the first to third inventions is established unless it departs from the nature thereof.

In the present invention constituted as described above, the filmy glass substrate having the thickness of 0.2 mm or less used as the supporting base material is flexible and lightweight. In addition, the mechanical strength of either the dye-sensitized photoelectric conversion element module or the photoelectric conversion element module can be improved by the provision of the resin system protective film, having the size equal to or larger than that of the filmy glass substrate, bonded to at least one surface of either the dye-sensitized photoelectric conversion element module or the photoelectric conversion element module. In addition thereto, the filmy glass substrate can resist the heating at the temperature of about 500°C. For this reason, in the dye-sensitized photoelectric conversion element, the burning treatment can be carried out at the high temperature of, for example, about 500°C in the phase of the formation of the porous semiconductor layer used in the dye-sensitized semiconductor layer. Therefore, the crystalline property and the bonding state of the particles in the porous semiconductor layer become satisfactory. As a result, the high electron conductivity can be obtained, and the high electric power generation efficiency can be obtained. In addition, since in the silicon system photoelectric conversion element, the process such as the deposition and heat treatment of the silicon film can be carried out at the high temperature up to about 500°C, the silicon film of good quality can be obtained, and the high electric power generation efficiency can be obtained.

According to the present invention, it is possible to realize either the dye-sensitized photoelectric conversion element module or the photoelectric conversion element module which can be structured so as to be lightweight, thin and flexible, and with which the high electric power generation efficiency can be obtained. Also, the high-performance electronic apparatus can be realized using either the excellent dye-sensitized photoelectric conversion element module or photoelectric conversion element module.

### Brief Description of Drawings

[FIG. 1] FIG. 1 is a cross sectional view of a dye-sensitized photoelectric conversion element module according to a first embodiment of the present invention.
[FIG. 2] FIG. 2 is an enlarged cross sectional view of a main portion of the dye-sensitized photoelectric conversion element module according to a first embodiment of the present invention.
[FIG. 3] FIG. 3 is a top plan view of the dye-sensitized photoelectric conversion element module according to the first embodiment of the present invention.
[FIG. 4] FIG. 4 is an enlarged top plan view of the main portion of the dye-sensitized photoelectric conversion element module according to the first embodiment of the present invention.
[FIG. 5] FIG. 5 is a cross sectional view for explaining a method of manufacturing the dye-sensitized photoelectric conversion element module according to the first embodiment of the present invention.
[FIG. 6] FIG. 6 is a cross sectional view of a dye-sensitized photoelectric conversion element module according to a second embodiment of the present invention.
[FIG. 7] FIG. 7 is an enlarged cross sectional view of a main portion of a dye-sensitized photoelectric conversion element module according to a third embodiment of the present invention.

### Best Modes for Carrying Out the Invention

Hereinafter, embodiments of the present invention will be described with reference to the drawings. It is noted that in the following embodiments, the same or corresponding portions are designated by the same reference numerals, respectively.

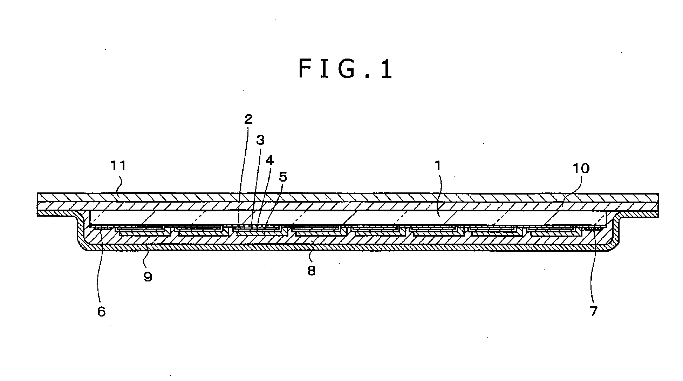

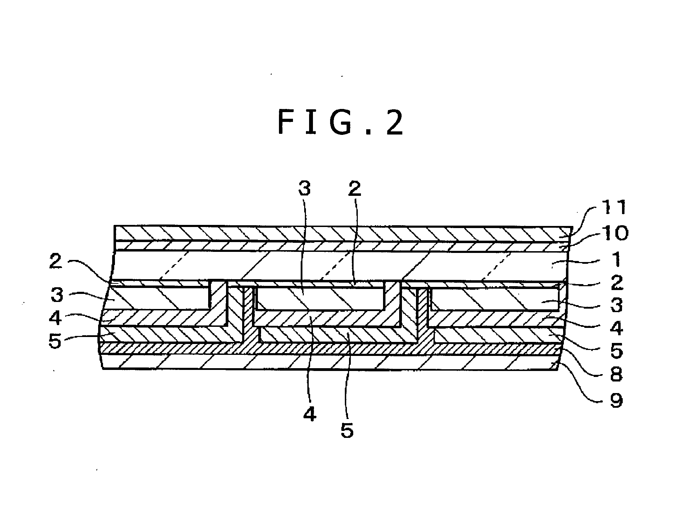

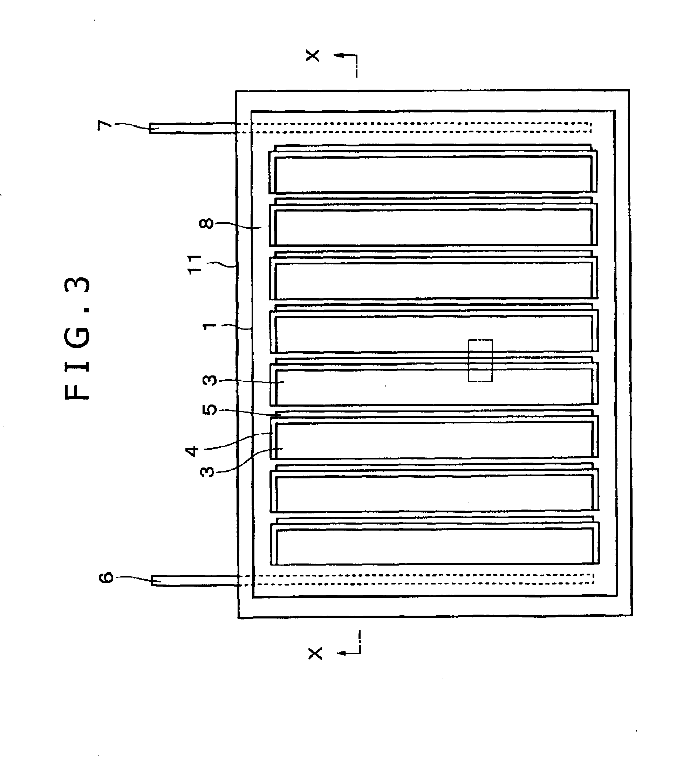

FIGS. 1 to 3 each show a dye-sensitized photoelectric conversion element module according to a first embodiment of the present invention. Here, FIG. 1 is a cross sectional view of the dye-sensitized photoelectric conversion element module, FIG. 2 is a cross sectional view of a main portion of the dye-sensitized photoelectric conversion element module, and FIG. 3 is a top plan view of the dye-sensitized photoelectric conversion element module. FIG. 1 corresponds to a cross sectional view taken on line X - X of FIG. 3, and FIG. 2 is a partially enlarged cross sectional view taken on line X - X of FIG. 3.

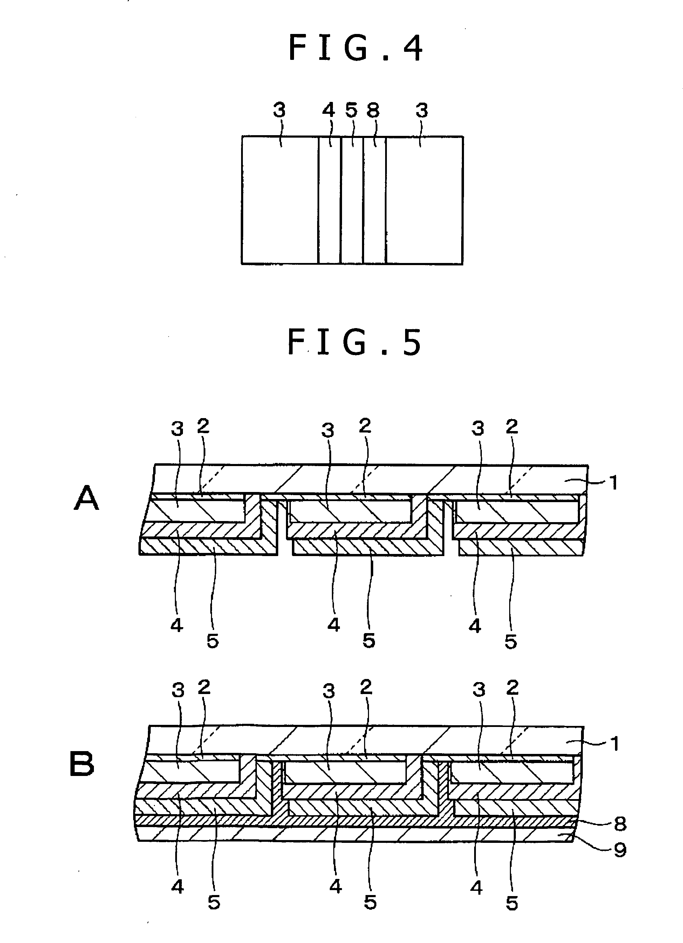

As shown in FIGS. 1 to 3, in this dye-sensitized photoelectric conversion element module, a plurality of stripe-shaped transparent conductive layers 2 are provided on an insulating transparent filmy glass substrate 1 in parallel with one another. A thickness of the filmy glass substrate 1 is set as being equal to or smaller than 0.2 mm, suitably, in the range of 0.01 to 0.2 mm. A stripe-shaped dye-sensitized semiconductor layer 3, a stripe-shaped porous insulating layer 4 and a stripe-shaped counter electrode 5 which extend in the same direction as that of each of the transparent conductive layers 2 are laminated in order on each of the transparent conductive layers 2, thereby structuring each of dye-sensitized photoelectric conversion elements. At least the dye-sensitized semiconductor layer 3 and the porous insulating layer 4 are entirely impregnated with an electrolyte, typically, the dye-sensitized semiconductor layer 3, the porous insulating layer 4 and the counter electrode 5 are entirely impregnated with the electrolyte. In this case, a width of the dye-sensitized semiconductor layer 3 is smaller than that of the transparent conductive layer 2, and a portion thereof adjacent to one side in a longitudinal direction of the transparent conductive layer 2 is exposed. A width of the porous insulating layer 4 is larger than that of the dye-sensitized semiconductor layer 3, and the porous insulating layer 4 is provided so as to cover the entire dye-sensitized semiconductor layer 3. One end of the porous insulating layer 4 extends along one side surface of the dye-sensitized semiconductor layer 3 to contact the filmy glass substrate 1, and the other end thereof extends along the other side surface of the dye-sensitized semiconductor layer 3 to contact the transparent conductive layer 2. In addition, one end of the counter electrode 5 of one dye-sensitized photoelectric conversion element is joined to the transparent conductive layer 2 of the adjacent dye-sensitized photoelectric conversion element. As a result, a plurality of dye-sensitized photoelectric conversion elements are electrically connected in series with one another. Although FIGS. 1 and 3 show the case where the eight dye-sensitized photoelectric conversion elements are connected in series with one another, it goes without saying that the number of dye-sensitized photoelectric conversion elements connected in series with one another is selected as may be necessary, and thus is not limited to eight. An extraction electrode 6 is connected to the transparent conductive layer 2 on which the dye-sensitized photoelectric conversion element is formed in one end of a plurality of dye-sensitized photoelectric conversion elements connected in series with one another. Also, an extraction electrode 7 is connected to the transparent conductive layer 2 which is formed adjacent to the transparent conductive layer 2 on which the dye-sensitized photoelectric conversion element is formed in the other end, and to which one end of the counter electrode 5 of the dye-sensitized photoelectric conversion element is connected. A bonding layer 8 is provided so as to cover an entire surface of a portion defined between the counter electrode 5 between each two dye-sensitized photoelectric conversion elements, and the porous insulating layer 4, and an entire surface of the counter electrode 5. A resin system protective film 9 having a size larger than that of the filmy glass substrate 1 is bonded to the entire surface of the bonding layer 8. On the other hand, a bonding layer 10 is entirely provided on a back surface of the filmy glass substrate 1, and a resin system protective film 11 having a size larger than that of the filmy glass substrate 1 is bonded to the entire surface of the bonding layer 10. Also, the protective film 9 and the protective film 11 are joined to each other in portions thereof each sticking out from the filmy glass substrate 1, whereby an end surface of the filmy glass substrate 1 is also covered with the protective film 9. Although transparent members are used as the protective film 11 and the bonding layer 10, respectively, bonded to the light incidence surface side, transparent members may be or not may be used as the protective film 9 and the bonding layer 8, respectively. A top plan view obtained by enlarging a portion (a portion surrounded by a chain line in FIG. 3) of the porous insulating layer 4, the counter electrode 5 and the bonding layer 8 is shown in FIG. 4.

A layer obtained by supporting a dye in either a semiconductor fine particle layer or a porous semiconductor layer is used as the dye-sensitized semiconductor layer 3. A resin system film made of a gas barrier material is suitably used as at least one of the protective films 9 and 11. For example, a film which is equal to or smaller than 100 (cc/m²/day/atm) in permeation rate of oxygen, and is equal to or smaller than 100 (g/m²/day) in permeation rate of water vapor is suitably used as at least one of the protective films 9 and 11. In addition, an antireflective (AR) film is suitably used as the protective film 11 on the light incidence side for the purpose of suppressing a loss of a light quantity of an incident light due to reflection.

Materials which are selected from those previously given as may be necessary can be used for the filmy glass substrate 1, the transparent conductive layer 2, the dye-sensitized semiconductor layer 3, the porous insulating layer 4, the counter electrode 5, and the bonding layers 8 and 10, respectively.

Next, a description will be given with respect to a method of manufacturing the dye-sensitized photoelectric conversion element module.

Firstly, as shown in A of FIG. 5, after the filmy glass substrate 1 is prepared and the transparent conductive layer 2 is formed over the entire surface of the filmy glass substrate 1, the transparent conductive layer 2 is patterned into stripe shapes by etching. Here, a substrate having a thickness of 0.2 mm or less may be used from the beginning as the filmy glass substrate 1 or a substrate having a thickness larger than 0.2 mm may be used as the filmy glass substrate 1. In the latter case, the filmy glass substrate 1 is thinned later through the polishing or the like to have a thickness of 0.2 mm or less. Next, a paste into which the semiconductor fine particles are dispersed is applied at a predetermined gap onto each of the transparent conductive layers 2. Next, the filmy glass substrate 1 is heated at a predetermined temperature to sinter the semiconductor fine particles, thereby forming a porous semiconductor layer made of the semiconductor fine particle sintered body.

Next, after the porous insulating layer 4 is formed over the entire surface, the porous insulating layer 4 is patterned into stripe shapes by etching. Next, the counter electrode 5 is formed over the entire surface of the porous insulating layer 4, and one end of the counter electrode 5 is joined to each of the transparent conductive layers 2.

Next, the filmy glass substrate 1 on which the porous semiconductor layer made of the semiconductor fine particle sintered body, the porous insulating layer 4, and the counter electrode 5 are formed in order, for example, is immersed in a dye solution, thereby supporting a dye for sensitizing in the semiconductor fine particles composing the porous semiconductor layer. In such a manner, the dye-sensitized semiconductor layer 3 is formed.

Next, an electrolyte is applied onto a surface on the counter electrode 5 side. Also, at least the dye-sensitized semiconductor layer 3 and the porous insulating layer 4 are entirely impregnated with the electrolyte, typically, the dye-sensitized semiconductor layer 3, the porous insulating layer 4 and the counter electrode 5 are entirely impregnated with the electrolyte.

Next, the extraction electrodes 6 and 7 are joined to the transparent conductive layer 2 on which the dye-sensitized photoelectric conversion element is formed in one end, and the transparent conductive layer 2 formed adjacent to the transparent conductive layer 2 on which the dye-sensitized photoelectric conversion element is formed in the other end, respectively.

Next, as shown in B of FIG. 5, a protective film 9 is bonded onto the surface on the counter electrode 5 side through the bonding layer 8.

Next, when the substrate having the thickness larger than 0.2 mm is used as the filmy glass substrate 1, the filmy glass substrate 1 is thinned through the polishing or the like to have the thickness of 0.2 mm or less.

After that, the protective film 11 is bonded onto the back surface of the filmy glass substrate 1 through the bonding layer 10, and the protective film 11 and the protective film 9 are joined to each other in the portions thereof sticking from the filmy glass substrate 1, thereby covering the end surface of the filmy glass substrate 1 with the protective film 9.

The dye-sensitized photoelectric conversion element module shown in FIGS. 1 to 3 is manufactured in the manner as described above.

Next, a description will be given with respect to an operation of the dye-sensitized photoelectric conversion element module.

A light which is transmitted through the filmy glass substrate 1 to be made incident from the filmy glass substrate 1 side excites the dye of the dye-sensitized semiconductor layer 3 to generate an electron. The electron is quickly delivered from the dye to the semiconductor fine particles of the dye-sensitized semiconductor layer 3. On the other hand, the dye which has lost the electron receives an electron from an ion in the electrolyte with which each of the dye-sensitized semiconductor layer 3 and the porous insulating layer 4 are entirely impregnated, and a molecule which has delivered the electron receives an electron again on the surface of the counter electrode 5. An electromotive force is generated between the transparent conductive layer 2 electrically connected to the dye-sensitized semiconductor layer 3, and the counter electrode 5 in accordance with the series of reactions. The photoelectric conversion is carried out in the manner as described above. In this case, a total electromotive force of the electromotive forces of the dye-sensitized photoelectric conversion elements is generated between the extraction electrode 6 connected to the transparent conductive layer 2 of the dye-sensitized photoelectric conversion element in one end of a plurality of dye-sensitized photoelectric conversion elements connected in series with one another, and the extraction electrode 7 connected to the transparent conductive layer 2 of the dye-sensitized photoelectric conversion element in the other end thereof.

According to the first embodiment, the filmy glass substrate 1 having the thickness of 0.2 mm or less, suitably, in the range of 0.01 to 0.2 mm is used as the supporting base material, the entire surface of the dye-sensitized photoelectric conversion element side, and the end surface of the filmy glass substrate 1 are covered with the protective film 9, and the entire back surface of the filmy glass substrate 1 is covered with the protective film 11. Therefore, the dye-sensitized photoelectric conversion element module can be structured so as to be lightweight, thin and flexible, and the mechanical strength of the dye-sensitized photoelectric conversion element module can also be sufficiently ensured. In addition, since the filmy glass substrate 1 is used as the supporting base material, the burning treatment in the phase of the formation of the porous semiconductor layer used in the dye-sensitized semiconductor layer 3 can be carried out at the temperature of about 500°C. As a result, the crystalline property of the porous semiconductor layer, and the bonding state of the particles can be made satisfactory, and thus the electron conductivity can be made satisfactory. For this reason, the electric power generation efficiency of the dye-sensitized photoelectric conversion element module can be increased. Moreover, the films made of the gas barrier materials are used as the protective films 9 and 11, respectively, which results in that gas such as oxygen, water vapor or the like can be prevented from penetrating from the outside into the inside of the dye-sensitized photoelectric conversion element module, and thus, it is possible to suppress deterioration of the characteristics such as the photoelectric conversion efficiency. For this reason, it is possible to realize the dye-sensitized photoelectric conversion element module which can maintain the excellent characteristics for a long period of time, and which can have the high durability. In addition, since the dye-sensitized semiconductor layer 3 and the counter electrode 5 are separated from each other through the porous insulating layer 4, the dye of the dye-sensitized semiconductor layer 3 can be prevented from being adsorbed on the counter electrode 5, and thus no deterioration of the characteristics is caused. Therefore, it is possible to realize the dye-sensitized photoelectric conversion element module which has the same performance of the electric power generation as that of the dye-sensitized solar cell module having the Z type structure.

A description will now be given with respect to Examples of the dye-sensitized photoelectric conversion element module.

### Example 1

An FTO glass substrate (having a sheet resistance of 10 Ω/□) for an amorphous solar cell, made by Nippon Sheet Glass Co., Ltd. was prepared in which an FTO film was formed on a glass substrate having a size of 60 mm × 46 mm, and a thickness of 4 mm. The FTO film was patterned by etching to nine stripe-shaped patterns so as to define a gap, having a width of 0.5 mm, between each two stripe-shaped patterns. After that, ultrasonic cleaning was carried out by using acetone, alcohol, an alkali system cleaning liquid, and ultrapure water in order, and drying was sufficiently carried out.

A titanium oxide paste made by Solaronix was applied onto the eight FTO films, with the exception of one FTO film at the termination, of the nine FTO films on the FTO glass substrate so as to obtain eight stripe-shaped patterns (a total area was 16 cm²) each having a width of 5 mm, and a length of 40 mm by using a screen printer. With regard to the paste, a transparent Ti-Nanoxide TSP paste, and a Ti-Nanoxide DSP containing therein scattering particles were laminated in order from the glass substrate side so as to have a thickness of 7 µm, and a thickness of 13 µm, respectively. As a result, a porous TiO₂ film having a thickness of 20 µm in total was obtained. After the resulting porous TiO₂ film was burnt in an electrical furnace at 500°C for 30 minutes, and the standing to cool was then carried out, the porous TiO₂ film was immersed in 0.1 mol/L of a TiCl₄ solution, was held at 70°C for 30 minutes, and was sufficiently cleaned by using pure water and ethanol. After drying, the porous TiO₂ film was burnt at 500°C for 30 minutes again. In such a way, a TiO₂ sintered body was manufactured.

Next, a TiO₂ paste for screen printing which was prepared by using commercially available TiO₂ particles (having a particle diameter of 200 nm), terpineol and ethyl cellulose was applied onto the TiO₂ sintered body described above so as to have a length of 41 mm, a width of 5.5 mm, and a thickness of 10 µm. The TiO₂ paste was dried, and the paste for the screen printing which was prepared by using the commercially available carbon black and graphite particles, and terpineol and ethyl cellulose was applied onto the TiO₂ layer described above so as to have a length of 40 mm, a width of 6 mm, and a thickness of 30 µm in order to form a counter electrode. Also, after the resulting paste was dried, the paste was burnt in the electrical furnace at 450°C for 30 minutes. In such a way, a porous insulating layer, and a porous counter electrode were formed.

Next, the TiO₂ sintered body was immersed in a tert-butylalcohol/acetonitrile mixed medium (1 : 1 in volume) of 0.5 mM of cis-bis (isothiocyanate)-N, N-bis (2,2'-dipyridyl-4,4'-dicarboxylic acid)-ruthenium (II) ditetrabutyl ammonium salt (N719 dye) at a room temperature for 48 hours, thereby supporting the dye in the TiO₂ sintered body. The TiO₂ sintered body having the dye thus supported therein was cleaned by using acetonitrile, and was then dried in a dark place. A dye-sensitized TiO₂ sintered body was manufactured in the manner as described above.

0.045g of sodium iodide (NaI), 1.11g of 1-propyl-2,3-dimethyl imidazolium iodide, 0.11g of iodine (I₂), and 0.081g of 4-tert-butyl pyridine were dissolved in 3g of γ-butyrolactone, thereby preparing an electrolyte composition.

Next, the electrolyte composition thus prepared was applied onto the entire surface on the counter electrode side by using the dispenser, and the insides of the counter electrode, the porous insulating layer, and the dye-sensitized semiconductor layer were impregnated with the electrolyte composition. Also, the extra electrolyte composition which exuded from the counter electrode, the porous insulating layer and the dye-sensitized semiconductor layer was clearly cleaned off.

Next, titanium foils each having a size of 60 mm × 3 mm, and a thickness of 30 µm were joined to extraction electrode joining portions provided on a transparent conductive layer formed from the FTO film on both ends of the FTO glass substrate by utilizing an ultrasonic soldering method, thereby forming the extraction electrodes 6 and 7, respectively.

Next, a protective film obtained by joining a hot-melt resin as a bonding layer to a sticking surface of a gas barrier film having aluminum evaporated thereon was cut into a piece having a size of 70 mm × 56 mm, and the resulting film was hot-pressed against a surface on a dye-sensitized photoelectric conversion element side under a reduced pressure, thereby obtaining a dye-sensitized photoelectric conversion element module.

Next, a back surface of the glass substrate having a thickness of 4 mm, and having the dye-sensitized photoelectric conversion element module thus formed thereon was successively polished through lap polishing and optical polishing, thereby obtaining a filmy glass substrate having a thickness of 0.1 mm.

An AR film (having a trade mark of "ARCTOP"), made by Asahi Glass Co., Ltd., which was cut to have the size of 70 mm × 56 mm was stuck onto a surface on a light incidence side of the dye-sensitized photoelectric conversion element module, that is, the back surface of the filmy glass substrate, and was joined to the protective film bonded to the dye-sensitized photoelectric conversion element side by thermo-compression bonding in a portion sticking out from the filmy glass substrate, thereby covering an end surface of the filmy glass substrate.

The desired dye-sensitized photoelectric conversion element module was obtained through the processes described above. In the dye-sensitized photoelectric conversion element module, eight dye-sensitized photoelectric conversion elements each having a size of 5 mm × 40 mm were connected in series with one another.

### Example 2

A dye-sensitized photoelectric conversion element module was manufactured similarly to the case of Example 1 except that a member in which a transparent conductive layer made of an ITO (having a thickness of 450 nm)/an ATO (having a thickness of 50 nm) was formed on a filmy glass substrate, having a thickness of 0.1 mm, which was subjected to a hardened glass treatment by utilizing sputtering so as to have the same pattern as that of the FTO film of Example 1 was used, and thus no back surface polishing for the filmy glass substrate was carried out.

### Comparative Example 1

A dye-sensitized photoelectric conversion element module was manufactured similarly to the case of Example 1 except that no back surface polishing for the glass substrate was carried out, and thus a thickness of 0.4 mm of the glass substrate was left as it is.

### Comparative Example 2

A dye-sensitized photoelectric conversion element module was manufactured similarly to the case of Example 2 except that no AR film was formed on a back surface of a filmy glass substrate as a protective film, a filmy glass substrate similarly having a thickness of 0.1 mm was covered with a filmy glass substrate having a thickness of 0.1 mm, and no protective film was formed on a surface as well on a dye-sensitized photoelectric conversion element side.

### Comparative Example 3

A plastic film (having a sheet resistance of 20 Ω/□, a size of 60 mm × 46 mm, and a thickness of 0.125 mm) in which an ITO film was evaporated on a polyethylene naphthalate (PEN) film was used as a transparent conductive substrate, and the ITO film was patterned into nine stripe-shaped patterns by utilizing the etching so as to define a gap, having a width of 0.5 mm, between each two stripe-shaped pattern. After that, ultrasonic cleaning was carried out by using acetone, alcohol, an alkali system cleaning liquid, and ultrapure water in order, and drying was sufficiently carried out.

A titanium oxide paste for low-temperature deposition (made by Peccell Technologies) was used as a titanium oxide paste, and was applied onto the eight ITO films except for one ITO film at the termination of the nine ITO films on the PEN/ITO substrate so as to obtain eight stripe-shaped patterns each having a width of 5 mm, and a length of 40 mm (having a total area of 16 cm²) by utilizing a doctor blade method. After this film was dried, this film was held on a hot plate at 150°C for 30 minutes. A porous TiO₂ layer was manufactured in the manner as described above.

Next, a TiO₂ paste for screen printing which was prepared by using commercially available TiO₂ particles (having a particle diameter of 200 nm), terpineol and ethyl cellulose was applied onto the porous TiO₂ layer described above so as to have a length of 41 mm, a width of 5.5 mm, and a thickness of 10 µm. The TiO₂ paste was dried, and the paste for the screen printing which was prepared by using the commercially available carbon black and graphite particles, and terpineol and ethyl cellulose was applied onto the TiO₂ layer described above so as to have a length of 40 mm, a width of 6 mm, and a thickness of 30 µm in order to form a counter electrode. Also, after the resulting paste was dried, the paste was held on the hot plate at 150°C for 30 minutes. In such a way, a porous insulating layer, and a porous counter electrode were formed.

Next, the porous TiO₂ layer was immersed in a tert-butylalcohol/acetonitrile mixed medium (1 : 1 in volume) of 0.5 mM of cis-bis (isothiocyanate)-N, N-bis (2,2'-dipyridyl-4,4'-dicarboxylic acid)-ruthenium (II) ditetrabutyl ammonium salt (N719 dye) at a room temperature for 48 hours, thereby supporting the dye in the porous TiO₂ layer. The porous TiO₂ layer having the dye thus supported therein was cleaned by using acetonitrile, and was then dried in a dark place. A dye-sensitized porous TiO₂ layer was manufactured in the manner as described above.

0.045g of sodium iodide (NaI), 1.11g of 1-propyl-2,3-dimethyl imidazolium iodide, 0.11g of iodine (I₂), and 0.081g of 4-tert-butyl pyridine were dissolved in 3g of γ-butyrolactone, thereby preparing an electrolyte composition.

Next, the electrolyte composition thus prepared was applied onto the entire surface on the counter electrode side by using the dispenser, and the insides of the counter electrode, the porous insulating layer, and the dye-sensitized semiconductor layer were impregnated with the electrolyte composition. Also, the extra electrolyte composition which exuded from the counter electrode, the porous insulating layer and the dye-sensitized semiconductor layer was clearly cleaned off.

Next, titanium foils each having a size of 60 mm × 3 mm, and a thickness of 30 µm were joined to extraction electrode joining portions provided on a transparent conduction layer formed from an ITO film on both sides of the PEN/ITO substrate by utilizing an ultrasonic soldering method, thereby forming extraction electrodes, respectively.

Next, a protective film obtained by joining a hot-melt resin as a bonding layer to a sticking surface of a gas barrier film having aluminum evaporated thereon was cut into a piece having a size of 70mm × 56 mm, and the resulting film was hot-pressed against a surface on a dye-sensitized photoelectric conversion element side under a reduced pressure, thereby perfectly covering a surface on a dye-sensitized photoelectric conversion element side of a dye-sensitized photoelectric conversion element module with the protective film.

The desired dye-sensitized photoelectric conversion element module was obtained through the processes described above. In the dye-sensitized photoelectric conversion element module, eight dye-sensitized photoelectric conversion elements each having a size of 5 mm × 40 mm were connected in series with one another.

The photoelectric conversion efficiency under the radiation condition of AM1.5 (1sun) was measured for the dye-sensitized photoelectric conversion element modules of Examples 1 and 2, and Comparative Examples 1 to 3 manufactured in the manners as described above. In addition, a bending test was carried out for the dye-sensitized photoelectric conversion element modules for which the measurement of the photoelectric conversion efficiency was completed, and radii of curvature right before the breaking was generated were calculated. The calculation results are shown in TABLE 1.

**[TABLE 1]**

| | photoelectric conversion efficiency % | minimum curvature radius (mm) | module weight (g) |
|---|---|---|---|
| Example 1 | 6.71 | 7.3 | 1.69 |
| Example 2 | 6.55 | 5.9 | 1.72 |
| Example 3 | 6.65 | 7.5 | 1.20 |
| Comparative Example 1 | 6.80 | measurement is impossible because of no bending | 28.6 |
| Comparative Example 2 | 6.66 | 23.1 | 1.45 |
| Comparative Example 3 | 1.29 | 3.1 (generation of film pealing) | 1.50 |
| Comparative Example 4 | 6.51 | 9.8 | 1.14 |

| | | | |
|---|---|---|---|
| * all data is average values for five samples manufactured | | | |

It is understood from TABLE 1 that the dye-sensitized photoelectric conversion element modules of Examples 1 and 2 are excellent in photoelectric conversion efficiency, small in minimum radius of curvature, and lightweight. Although Comparative Example 1 shows the high photoelectric conversion efficiency because the glass substrate has the large thickness of 4 mm, the radius of curvature could not be measured because the dye-sensitized photoelectric conversion element module was not bent, and in addition thereto, the weight was very heavy. Although Comparative Example 2 shows the high photoelectric conversion efficiency, the radius of curvature is very large as compared with the case of each of Examples 1 and 2. Although Comparative Example 3 is an example in which the dye-sensitized photoelectric conversion element module was manufactured by not using the filmy glass substrate, but using the PEN/ITO substrate, the photoelectric conversion efficiency is very low because no burning process was carried out at 500°C in the phase of formation of the porous TiO₂ layer.

Next, a description will be given with respect to a dye-sensitized photoelectric conversion element module according to a second embodiment of the present invention.

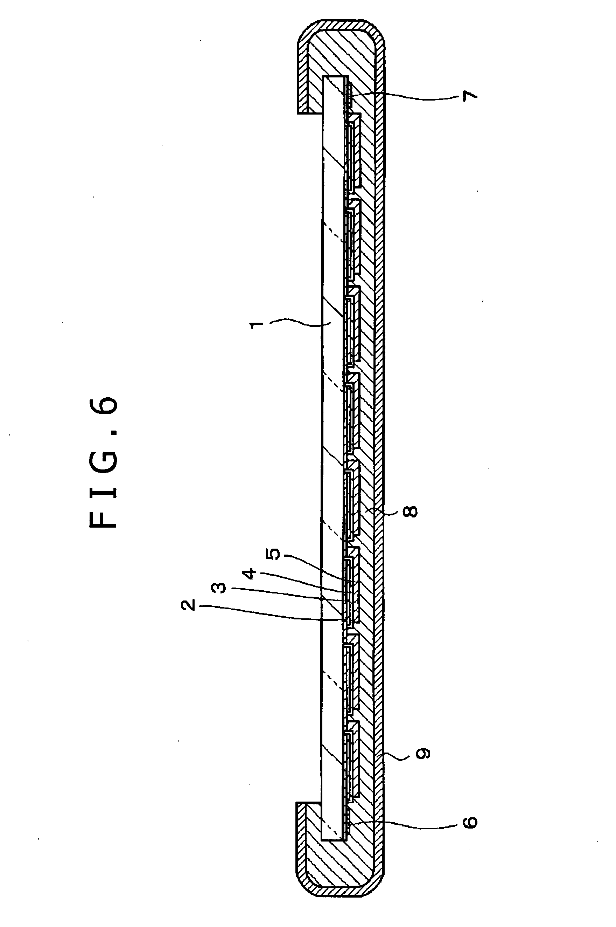

As shown in FIG. 6, in this dye-sensitized photoelectric conversion element module, no protective film 11 is bonded onto the back surface of the filmy glass substrate 1, and the protective film 9 bonded onto the surface on the dye-sensitized photoelectric conversion element side is folded at the end surface of the filmy glass substrate 1 to be joined to the back surface of the filmy glass substrate 1. Other structures of this dye-sensitized photoelectric conversion element module are the same as those of the dye-sensitized photoelectric conversion element module according to the first embodiment.

A method of manufacturing this dye-sensitized photoelectric conversion element module is the same as that of the dye-sensitized photoelectric conversion element module according to the first embodiment except that no protective film 11 is bonded onto the back surface of the filmy glass substrate 1, and the protective film 9 is folded at the end surface of the filmy glass substrate 1.

According to the second embodiment, it is possible to obtain the same advantages as those in the first embodiment.

A description will now be given with respect to Examples of the dye-sensitized photoelectric conversion element module.

### Example 3

A dye-sensitized photoelectric conversion element module was manufactured similarly to the case of Example 1 except that no AR film was bonded onto a back surface of a filmy glass substrate, and a protective film bonded onto a surface on the dye-sensitized photoelectric conversion element side was folded at an end surface of the filmy glass substrate to be joined to the back surface of the filmy glass substrate.

### Comparative Example 4

A dye-sensitized photoelectric conversion element module was manufactured similarly to the case of Example 3 except that a size of a protective film to be bonded onto a surface on a dye-sensitized photoelectric conversion element side was set as a size of 58 mm × 44 mm smaller than that of (60 mm × 46 mm) of a filmy glass substrate, and the protective film was bonded so as to expose an end surface of the filmy glass substrate.

The photoelectric conversion efficiency under the radiation condition of AM1.5 (1sun) was measured for the dye-sensitized photoelectric conversion element modules of Example 3 and Comparative Example 4 manufactured in the manners as described above. In addition, a bending test was carried out for the dye-sensitized photoelectric conversion element modules for which the measurement of the photoelectric conversion efficiency was completed, and radii of curvature right before the breaking was generated were calculated. The calculation results are shown in TABLE 1.

It is understood from TABLE 1 that the dye-sensitized photoelectric conversion element module of Example 3 is excellent in photoelectric conversion efficiency, small in minimum radius of curvature, and lightweight. Although Comparative Example 4 shows the high photoelectric conversion efficiency, a radius of curvature is large as compared with the case of Example 3 because the size of the protective film is smaller than that of the filmy glass substrate, and thus the end surface of the filmy glass substrate is covered with no protective film.

Next, a description will be given with respect to a dye-sensitized photoelectric conversion element module according to a third embodiment of the present invention.

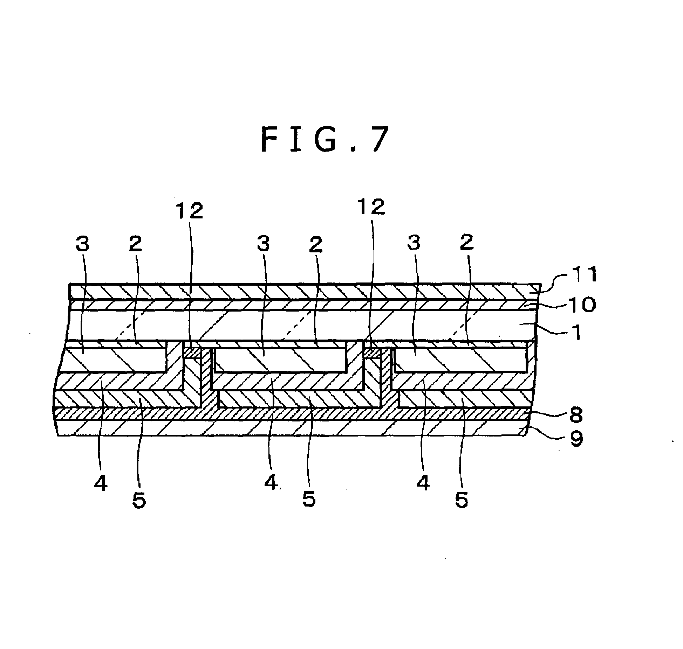

As shown in FIG. 7, in this dye-sensitized photoelectric conversion element module, a counter electrode 5 is formed from a foil made of either a material having a catalyst layer containing therein at least one or more kinds of elements selected from the group consisting of Pt, Ru, Ir and C or a material containing therein at least one or more kinds of elements selected from the group consisting of Pt, Ru, Ir and C which is provided on one surface, on a side of the porous insulating layer 4, of a foil made of either a metal or an alloy containing therein at least one or more kinds of elements selected from the group consisting of Ti, Ni, Cr, Fe, Nb, Ta, W, Co and Zr. Also, one end of the counter electrode 5 of one dye-sensitized photoelectric conversion element is joined to the transparent conductive layer 2 of the adjacent dye-sensitized photoelectric conversion element through a conductive material 12. Other structures of this dye-sensitized photoelectric conversion element module are the same as those in the dye-sensitized photoelectric conversion element module according to the first embodiment.

Next, a description will be given with respect to a method of manufacturing this dye-sensitized photoelectric conversion element module.

Firstly, after the process is advanced similarly to the case of the first embodiment, thereby forming up to the porous insulating layer 4, a conductive material 12 is formed on a joining portion to the counter electrode 5 on each of the transparent conductive layers 2. Also, the counter electrode 5 formed from the foil made of either the material having the catalyst layer or the material having the catalytic ability on one surface of the foil, made of either the metal or the alloy, having the predetermined shape is formed, and is then joined to the conductive material 12.

Next, the extraction electrodes 6 and 7 are formed similarly to the case of the first embodiment.

Next, the bonding layer 8 is formed over the entire surface of the portion defined between the counter electrode 5 between each two dye-sensitized photoelectric conversion elements, and the porous insulating layer 4, and the entire surface of the counter electrode 5 except for a portion of a liquid injection hole which is previously formed every dye-sensitized photoelectric conversion element.

Next, an electrolyte solution is injected through the liquid injection hole previously formed every dye-sensitized photoelectric conversion element, thereby impregnating entirely at least the dye-sensitized semiconductor layer 3, and the porous insulating layer 4, typically, entirely the dye-sensitized semiconductor layer 3, the porous insulating layer 4 and the counter electrode 5 with the electrolyte.

After that, the process in and after the bonding of the protective film 9 is advanced similarly to the case of the first embodiment, thereby manufacturing the dye-sensitized photoelectric conversion element module.

According to the third embodiment, in addition to the advantages similar to the case of the first embodiment, the following advantages can be obtained. That is to say, since the counter electrode 5 is formed from the foil made of either the material having the catalyst layer or the material having the catalytic ability on the foil made of either the metal or the alloy, the counter electrode 5 can be structured to be thin, and thus the thinning and weight saving of the dye-sensitized photoelectric conversion element module become possible. In addition, the materials of the foil made of either the metal or the alloy, and the catalyst layer, or the material having the catalytic ability which form the counter electrode 5 have the wide room of selection, and thus there is no restriction in material of the counter electrode. Moreover, since the dye-sensitized semiconductor layer 3 and the counter electrode 5 are separated from each other through the porous insulating layer 4, the dye of the dye-sensitized semiconductor layer 3 can be prevented from being adsorbed on the counter electrode 5, and thus no deterioration of the characteristics is caused. Therefore, it is possible to realize the dye-sensitized photoelectric conversion element module which has the same performance of the electric power generation as that of a dye-sensitized solar cell module having a Z type structure.

A description will now be given with respect to Examples of a dye-sensitized photoelectric conversion element module.

### Example 4

After the process was advanced similarly to the case of Example 1 to make the dye-sensitized TiO₂ sintered body by using the FTO glass substrate, an anisotropically conductive paste was applied onto the stripe-shaped dye-sensitized TiO₂ sintered body to have a width of 0.5 mm so as to be parallel with the stripe-shaped dye-sensitized TiO₂ sintered body, and was then dried.

Next, a counter electrode obtained by spray-coating one surface of a titanium foil having a thickness of 0.05 mm with an isopropyl alcohol (IPA) solution of 0.05 mM of a chloroplatinic acid, and carrying out the burning at 385°C was cut into pieces each having a size of 6 mm × 40 mm. Also, after the surface onto which the chloroplatinic acid was sprayed was directed toward the dye-sensitized TiO₂ sintered body side, thereby carrying out the alignment, the anisotropically conductive paste described above, and the counter electrode were joined to each other by thermo-compression bonding.

An UV cure adhesive agent was applied onto the FTO glass substrate by carrying out the screen printing so as to cover all the dye-sensitized photoelectric conversion elements with a pattern for liquid injection having a diameter of 1 mm being left. After the application, when air bubbles perfectly outgassed, an ultraviolet light was radiated to the UV cure adhesive agent by using a conveyer type UV exposure system, thereby curing the UV cure adhesive agent.

Next, after the electrolyte composition prepared similarly to the case of Example 1 was injected under a reduced pressure through the liquid injection hole, having a diameter of 1 mm, prepared in the manner as described above, the electrolyte composition was held under an increased pressure of 0.4 MPa for 30 minutes, so that the electrolyte solution was made to perfectly penetrate into each of the dye-sensitized photoelectric conversion elements. In such a way, each of the dye-sensitized TiO₂ sintered body and the porous insulating layer was impregnated with the electrolyte.

Next, after the liquid injection hole for the electrolyte solution was sealed with the UV cure adhesive agent, similarly to the case of Example 1, a protective film was bonded to the dye-sensitized photoelectric conversion element side. Also, after the glass substrate was polished to obtain a filmy glass substrate having a thickness of 0.1 mm, a protective film was bonded to a back surface of the resulting filmy glass substrate, and these protective films are joined to each other in portions thereof sticking out from the filmy glass substrate, thereby obtaining a dye-sensitized photoelectric conversion element module.

Next, a description will be given with respect to a dye-sensitized photoelectric conversion element module according to a fourth embodiment of the present invention.

In this dye-sensitized photoelectric conversion element module, in the dye-sensitized photoelectric conversion element module according to the first embodiment, an electrolyte is made of an electrolyte composition which contains therein iodine, and contains therein a compound having at least one isocyanate group (-NCO), in which the compound suitably contains therein at least one or more nitrogen containing functional groups within the same molecule in addition to the isocyanate group, or which further contains therein a compound having at least one or more nitrogen containing functional groups in addition to that compound. Although there is especially no limit to the compound having at least one or more isocyanate groups (-NCO), the compound is preferably compatible with a solvent of an electrolyte, an electrolyte salt, and other addition agents. Although the compound having at least one or more nitrogen contacting functional group is suitably an amine system compound, the compound concerned is not especially limited thereto. Although there is especially no limit to the amine system compound, the amine system compound is preferably compatible with a solvent of an electrolyte, an electrolyte salt, and other addition agents. The nitrogen containing functional group is made to exist together with the compound having at least one or more isocyanate groups, which especially, largely contributes to an increase in open voltage of the dye-sensitized photoelectric conversion element modules. Specifically, the compound having at least one or more isocyanate groups, for example, is isocyanic phenyl, isocyanic 2-chloroethyl, isocyanic m-chlorophenyl, isocyanic cychlohexyl, isocyanic o-tolyl, isocyanic p-tolyl, isocyanic n-hexyl, 2,4-diisocyanic tolylene, diisocyanic hexamethylene, 4,4'-diisocyanic methylenediphenyl or the like. However, the present invention is by no means limited thereto. In addition, specifically, the amine system compound, for example, is 4-tert-butylpyridine, aniline, N,N-dimethylaniline, N-methylbenz imidazole, or the like. However, the present invention is by no means limited thereto.

Any of the matters other than the foregoing is similar to that in the dye-sensitized photoelectric conversion element module according to the first embodiment.

According to the fourth embodiment, in addition to the same advantage as that of the first embodiment, it is possible to obtain an advantage that the electrolyte is made of the electrolyte compound containing therein the compound having at least one or more isocyanate groups, which results in that both the short current and the open voltage can be increased, thereby making it possible to obtain the dye-sensitized photoelectric conversion element module having the very high photoelectric conversion efficiency.

A description will now be given with respect to Example of the dye-sensitized photoelectric conversion element module.

### Example 5

During the preparation of the electrolyte compound in Example 1, in addition to 0.045g of sodium iodide (NaI), 1.11g of 1-propyl-2,3-dimethyl imidazolium iodide, 0.11g of iodine (I₂), and 0.081g of 4-tert-butyl pyridine, 0.071g (0.2 mol/L) of phenyl isocyanurate was dissolved in 3g of γ-butyrolactone. Any of other matters is made similar to that in Example 1, and a dye-sensitized photoelectric conversion element module was obtained.

Although the embodiments of the present invention, and Examples of the embodiments have been concretely described so far, the present invention is by no means limited to the embodiments and Examples described above, and thus various changes based on the technical idea of the present invention can be made.

For example, the numerical values, the structures, the shapes, the materials, the raw materials, the processes, and the like which have been given in the embodiments and Examples described above are merely an example, and thus numerical values, structures, shapes, materials, raw materials, processes and the like which are different from those given in the embodiments and Examples described above may be used as may be necessary.

## Claims

1. A dye-sensitized photoelectric conversion element module having a plurality of dye-sensitized photoelectric conversion elements on a supporting base material, wherein
a filmy glass substrate having a thickness of 0.2 mm or less is used as said supporting base material, and a resin system protective film having a size equal to or larger than that of said filmy glass substrate is bonded to at least one surface of said dye-sensitized photoelectric conversion element module.

2. The dye-sensitized photoelectric conversion element module according to claim 1, wherein at least a part of an end surface of said filmy glass substrate is covered with said protective film.

3. The dye-sensitized photoelectric conversion element module according to claim 2, wherein said end surface of at least one or more sides of said filmy glass substrate is covered with said protective film.

4. The dye-sensitized photoelectric conversion element module according to claim 3, wherein said dye-sensitized photoelectric conversion element module has a transparent conductive layer on a plurality of areas on said filmy glass substrate, a dye-sensitized semiconductor layer, a porous insulating layer and a counter electrode are laminated in order on said transparent conductive layer, thereby structuring said dye-sensitized photoelectric conversion element, and said protective film is bonded to a surface on a side of said dye-sensitized photoelectric conversion element of said dye-sensitized photoelectric conversion element module, thereby covering said dye-sensitized photoelectric conversion element with said protective film.

5. The dye-sensitized photoelectric conversion element module according to claim 4, wherein said transparent conductive layer of one dye-sensitized photoelectric conversion element, and said counter electrode of another dye-sensitized photoelectric conversion element are electrically connected to each other in a portion defined between the two dye-sensitized photoelectric conversion elements adjacent to each other.

6. The dye-sensitized photoelectric conversion element module according to claim 5, wherein at least said dye-sensitized semiconductor layer and said porous insulating layer are impregnated with an electrolyte.

7. The dye-sensitized photoelectric conversion element module according to claim 6, wherein said electrolyte is composed of an electrolyte composition containing therein a compound having at least one or more isocyanate groups.

8. The dye-sensitized photoelectric conversion element module according to claim 4, wherein said counter electrode is formed from a foil made of either a material having a catalyst layer, or a material having a catalytic ability on one surface, on a side of said porous insulating layer, of said foil made of either the metal or the alloy.

9. A method of manufacturing a dye-sensitized photoelectric conversion element module having a plurality of dye-sensitized photoelectric conversion elements on a supporting base material, said method comprising:
the step of using a filmy glass substrate having a thickness of 0.2 mm or less as said supporting base material, and forming said plurality of dye-sensitized photoelectric conversion elements on said filmy glass substrate, thereby forming said dye-sensitized photoelectric conversion element module; and
the step of bonding a resin system protective film having a size equal to or larger than that of said filmy glass substrate to at least one surface of said dye-sensitized photoelectric conversion element module.

10. An electronic apparatus using a dye-sensitized photoelectric conversion element module, wherein
said dye-sensitized photoelectric conversion element module is a dye-sensitized photoelectric conversion element module having a plurality of dye-sensitized photoelectric conversion elements on a supporting base material; and
a filmy glass substrate having a thickness of 0.2 mm or less is used as said supporting base material, and a resin system protective film having a size equal to or larger than that of said filmy glass substrate is bonded to at least one surface of said dye-sensitized photoelectric conversion element module.

11. A photoelectric conversion element module having a plurality of photoelectric conversion elements on a supporting base material, wherein
a filmy glass substrate having a thickness of 0.2 mm or less is used as said supporting base material, and a resin system protective film having a size equal to or larger than that of said filmy glass substrate is bonded to at least one surface of said photoelectric conversion element module.

12. A method of manufacturing a photoelectric conversion element module having a plurality of photoelectric conversion elements on a supporting base material, said method comprising:
the step of using a filmy glass substrate having a thickness of 0.2 mm or less as said supporting base material, and forming said plurality of photoelectric conversion elements on said filmy glass substrate, thereby forming said photoelectric conversion element module; and
the step of bonding a resin system protective film having a size equal to or larger than that of said filmy glass substrate to at least one surface of said photoelectric conversion element module.

13. An electronic apparatus using a photoelectric conversion element module, wherein
said photoelectric conversion element module is a photoelectric conversion element module having a plurality of photoelectric conversion elements on a supporting base material; and
a filmy glass substrate having a thickness of 0.2 mm or less is used as said supporting base material, and a resin system protective film having a size equal to or larger than that of said filmy glass substrate is bonded to at least one surface of said photoelectric conversion element module.
